# EUROPEAN PATENT APPLICATION

(11) **EP 3 345 971 A1**
(43) Date of publication of application: **11.07.2018**
(21) Application number: 16841652.7
(22) Date of filing: 25.08.2016
(51) Int. Cl.: C08L 101/00, C08K 5/13, C08L 63/00, C08L 65/00, C08G 59/62

(54) **RESIN COMPOSITION**

(30) Priority: 31.08.2015 JP 2015170554
(71) Applicant: Zeon Corporation, Tokyo 100-8246 (JP)
(72) Inventor: TSUTSUMI, Takashi, Tokyo 100-8246 (JP); SAITO, Takayuki, Tokyo 100-8246 (JP); FUJIMURA, Makoto, Tokyo 100-8246 (JP)
(74) Representative: Hansen, Norbert
(86) International application number: PCT/JP2016/074809
(87) International publication number: WO 2017/038620

(57) **Abstract**

A resin composition comprising a binder resin (A), an aromatic compound (B) represented by the following general formula (1), and a cross-linking agent (C): 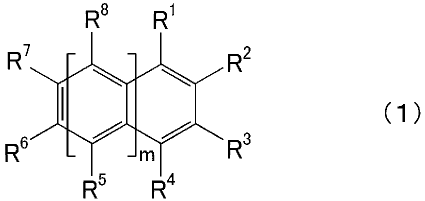 where in the general formula (1), each of R¹ to R⁸ respectively independently is hydrogen atom, hydroxyl group, carboxyl group, substituted or unsubstituted aliphatic hydrocarbon group having 1 to 12 carbon atoms, or substituted or unsubstituted aromatic hydrocarbon group having 6 to 12 carbon atoms, "m" is an integer of 0 to 2, when "m" is 0, at least two of R¹ to R⁴, R⁶, and R⁷ are hydroxyl group, when "m" is 1 or 2, at least two of R¹ to R⁸ are hydroxyl group, and, when "m" is 2 or more, regardless of the structure represented by general formula (1), three or more benzene rings present may be joined with each other at any positions.

## Description

### TECHNICAL FIELD

The present invention relates to a resin composition and an electronic device having a resin film comprised of that resin composition, more particularly relates to a resin composition able to give a resin film excellent in heat resistance, waterproofness, thermal shock resistance, and solvent resistance and an electronic device having a resin film comprised of that resin composition.

### BACKGROUND ART

Various display devices such as organic EL devices and liquid crystal display devices, integrated circuit devices, solid state imaging devices, color filters, black matrices, and other electronic devices have various resin films as surface protective films for preventing degradation or damage, flattening films for flattening the device surfaces and interconnects, interlayer insulating films for insulating between interconnects laid out in layers, etc.

In the past, as the resin materials for forming these resin films, thermosetting resin materials such as epoxy resins, polyimides, and polybenzoxazoles have been widely used. In recent years, along with the higher densities of interconnects and devices, in these resin materials as well, development of new resin materials excellent in electrical characteristics such as a low dielectric property has been sought.

To deal with these demands, for example, Patent Document 1 discloses a resin composition containing a cyclic olefin polymer (A) having a protic polar group, a cross-linking agent (B), and a radiation-sensitive compound (C) in which the content of the radiation-sensitive compound (C) is 10 to 45 parts by weight with respect to 100 parts by weight of the cyclic olefin polymer (A). However, according to the radiation-sensitive resin composition described in this Patent Document 1, while it is possible to form a resin film excellent in electrical characteristics such as a low dielectric property and further excellent in heat resistance and solvent resistance, but the waterproofness and thermal shock resistance are insufficient. Therefore, improvement of the waterproofness and thermal shock resistance has been desired.

### RELATED ART

### PATENT DOCUMENTS

Patent Document 1: Japanese Patent Publication No. 2009-295374A

### SUMMARY OF INVENTION

### PROBLEM TO BE SOLVED BY THE INVENTION

The present invention has as its object the provision of a resin composition able to give a resin film excellent in heat resistance, waterproofness, thermal shock resistance, and solvent resistance and an electronic device having a resin film comprised of such a resin composition.

### MEANS FOR SOLVING THE PROBLEM

The inventors engaged in intensive research to achieve the above object and as a result discovered that the above object can be achieved by a resin composition obtained by mixing a specific aromatic compound having two or more phenolic hydroxyl groups and a cross-linking agent into a binder resin and thereby completed the present invention.

That is, according to the present invention, there are provided:
[1] A resin composition comprising a binder resin (A), an aromatic compound (B) represented by the following general formula (1), and a cross-linking agent (C): 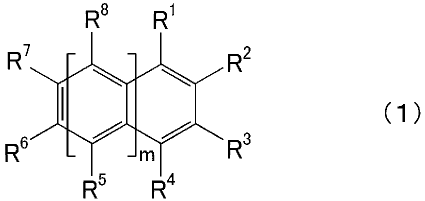 where in the general formula (1), each of R¹ to R⁸ respectively independently is hydrogen atom, hydroxyl group, carboxyl group, substituted or unsubstituted aliphatic hydrocarbon group having 1 to 12 carbon atoms, or substituted or unsubstituted aromatic hydrocarbon group having 6 to 12 carbon atoms, "m" is an integer of 0 to 2, when "m" is 0, at least two of R¹ to R⁴, R⁶, and R⁷ are hydroxyl group, when "m" is 1 or 2, at least two of R¹ to R⁸ are hydroxyl group, and, when "m" is 2 or more, regardless of the structure represented by general formula (1), three or more benzene rings present may be joined with each other at any positions,
[2] The resin composition according to [1], further comprising a photoacid generator (D),
[3] The resin composition according to [2], wherein the photoacid generator (D) is a quinone diazide compound,
[4] The resin composition according to any one of [1] to [3], wherein the binder resin (A) is a cyclic olefin polymer having a protic polar group,
[5] The resin composition according to any one of [1] to [4], wherein the aromatic compound (B) is a compound represented by the following general formula (2): 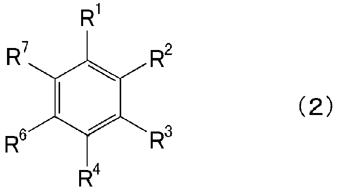 where in the general formula (2), R¹ to R⁴, R⁶, and R⁷ are the same as in the general formula (1) and at least two of R¹ to R⁴, R⁶, and R⁷ are hydroxyl group,
[6] The resin composition according to [5], wherein the aromatic compound (B) is
   a compound represented by the general formula (2) in which two of R¹ to R⁴, R⁶, and R⁷ are hydroxyl group, one of R¹ to R⁴, R⁶, and R⁷ is an aliphatic hydrocarbon group having 1 to 12 carbon atoms, and the remainder are hydrogen atom, or
   a compound represented by the general formula (2) in which three of R¹ to R⁴, R⁶, and R⁷ are hydroxyl group and the remainder are hydrogen atom,
[7] The resin composition according to any one of [1] to [6], wherein a content of the aromatic compound (B) is 0.01 to 30 parts by weight with respect to 100 parts by weight of the binder resin (A),
[8] The resin composition according to any one of [1] to [7], wherein the cross-linking agent (C) is an epoxy group-containing cross-linking agent, and
[9] An electronic device having a resin film comprised of a resin composition according to any one of [1] to [8].

### EFFECTS OF INVENTION

According to the present invention, it is possible to provide a resin composition able to give a resin film excellent in heat resistance, waterproofness, thermal shock resistance, and solvent resistance and an electronic device having a resin film comprised of such a resin composition.

### DESCRIPTION OF EMBODIMENTS

The resin composition of the present invention comprises a binder resin (A), an aromatic compound (B) represented by the general formula (1) described below, and a cross-linking agent (C).

### (Binder Resin (A))

The binder resin (A) used in the present invention is not particularly limited, but a cyclic olefin polymer which has a protonic polar group (A1), an acrylic resin (A2), polyimide or its precursor (A3), polybenzoxazole or its precursor (A4), polysiloxane (A5), or phenol resin (A6) is preferable. Among these as well, from the view point that it is possible to further improve the waterproofness of the resin composition of the present invention, a cyclic olefin polymer which has a protonic polar group (A1) is particularly preferable.

These binder resins (A) may respectively be used alone or as two types or more combined.

As the cyclic olefin polymer which has a protonic polar group (A1) (below, simply referred to as the "cyclic olefin polymer (A1)"), a polymer of one or more cyclic olefin monomers or a copolymer of one or more cyclic olefin monomers and a monomer which can copolymerize with them may be mentioned, but in the present invention, as the monomer for forming the cyclic olefin polymer (A1), it is preferable to use at least a cyclic olefin monomer which has a protonic polar group (a).

Here, the "protonic polar group" means a group which contains an atom belonging to Group XV or Group XVI of the Periodic Table to which a hydrogen atom directly bonds. Among the atoms belonging to Group XV or Group XVI of the Periodic Table, atoms belonging to Period 1 or Period 2 of Group XV or Group XVI of the Periodic Table are preferable, an oxygen atom, nitrogen atom, or sulfur atom is more preferable, and an oxygen atom is particularly preferable.

As specific examples of such a protonic polar group, a hydroxyl group, carboxy group (hydroxycarbonyl group), sulfonic acid group, phosphoric acid group, and other polar groups which have oxygen atoms; primary amino group, secondary amino group, primary amide group, secondary amide group (imide group), and other polar groups which have nitrogen atoms; a thiol group and other polar groups which have sulfur atoms; etc. may be mentioned. Among these as well, ones which have oxygen atoms are preferable, carboxy group is more preferable.

In the present invention, the number of protonic polar groups which bond with the cyclic olefin resin which has protonic polar groups is not particularly limited. Further, different types of protonic polar groups may also be included.

As specific examples of the cyclic olefin monomer which has a protonic polar group (a) (below, suitably called the "monomer (a)"), a carboxy group-containing cyclic olefin such as 2-hydroxycarbonylbicyclo[2.2.1]hept-5-ene, 2-methyl-2-hydroxycarbonylbicyclo[2.2.1]hept-5-ene, 2-carboxymethyl-2-hydroxycarbonylbicyclo[2.2.1]hept-5-ene, 2-hydroxycarbonyl-2-methoxycarbonylmethylbicyclo[2.2.1]hept-5-ene, 2-hydroxycarbonyl-2-ethoxycarbonylmethylbicyclo[2.2.1]hept-5-ene, 2-hydroxycarbonyl-2-propoxycarbonylmethylbicyclo[2.2.1]hept-5-ene, 2-hydroxycarbonyl-2-butoxycarbonylmethylbicyclo[2.2.1]hept-5-ene, 2-hydroxycarbonyl-2-pentyloxycarbonylmethylbicyclo[2.2.1]hept-5-ene, 2-hydroxycarbonyl-2-hexyloxycarbonylmethylbicyclo[2.2.1]hept-5-ene, 2-hydroxycarbonyl-2-cyclohexyloxycarbonylmethylbicyclo[2.2.1]hept-5-ene, 2-hydroxycarbonyl-2-phenoxycarbonylmethylbicyclo[2.2.1]hept-5-ene, 2-hydroxycarbonyl-2-naphthyloxycarbonylmethylbicyclo[2.2.1]hept-5-ene, 2-hydroxycarbonyl-2-biphenyloxycarbonylmethylbicyclo[2.2.1]hept-5-ene, 2-hydroxycarbonyl-2-benzyloxycarbonylmethylbicyclo[2.2.1]hept-5-ene, 2-hydroxycarbonyl-2-hydroxyethoxycarbonylmethylbicyclo[2.2.1]hept-5-ene, 2,3-dihydroxycarbonylbicyclo[2.2.1]hept-5-ene, 2-hydroxycarbonyl-3-methoxycarbonylbicyclo[2.2.1]hept-5-ene, 2-hydroxycarbonyl-3-ethoxycarbonylbicyclo[2.2.1]hept-5-ene, 2-hydroxycarbonyl-3-propoxycarbonylbicyclo[2.2.1]hept-5-ene, 2-hydroxycarbonyl-3-butoxycarbonylbicyclo[2.2.1]hept-5-ene, 2-hydroxycarbonyl-3-pentyloxycarbonylbicyclo[2.2.1]hept-5-ene, 2-hydroxycarbonyl-3-hexyloxycarbonylbicyclo[2.2.1]hept-5-ene, 2-hydroxycarbonyl-3-cyclohexyloxycarbonylbicyclo[2.2.1]hept-5-ene, 2-hydroxycarbonyl-3-phenoxycarbonylbicyclo[2.2.1]hept-5-ene, 2-hydroxycarbonyl-3-naphthyloxycarbonylbicyclo[2.2.1]hept-5-ene, 2-hydroxycarbonyl-3-biphenyloxycarbonylbicyclo[2.2.1]hept-5-ene, 2-hydroxycarbonyl-3-benzyloxycarbonylbicyclo[2.2.1]hept-5-ene, 2-hydroxycarbonyl-3-hydroxyethoxycarbonylbicyclo[2.2.1]hept-5-ene, 2-hydroxycarbonyl-3-hydroxycarbonylmethylbicyclo[2.2.1]hept-5-ene, 3-methyl-2-hydroxycarbonylbicyclo[2.2.1]hept-5-ene, 3-hydroxymethyl-2-hydroxycarbonylbicyclo[2.2.1]hept-5-ene, 2-hydroxycarbonyltricyclo[5.2.1.0^{2,6}]deca-3,8-diene, 4-hydroxycarbonyltetracyclo[6.2.1.1^{3,6}.0^{2,7}]dodec-9-ene, 4-methyl-4-hydroxycarbonyltetracyclo[6.2.1.1^{3,6}.0^{2,7}]dodec-9-ene, 4,5-dihydroxycarbonyltetracyclo[6.2.1.1^{3,6}.0^{2,7}]dodec-9-ene, 4-carboxymethyl-4-hydroxycarbonyltetracyclo[6.2.1.1^{3,6}.0^{2,7}]dodec-9-ene, N-(hydroxycarbonylmethyl)bicyclo[2.2.1]hept-5-ene-2,3-dicarboxyimide, N-(hydroxycarbonylethyl)bicyclo[2.2.1]hept-5-ene-2,3-dicarboxyimide, N-(hydroxycarbonylpentyl)bicyclo[2.2.1]hept-5-ene-2,3-dicarboxyimide, N-(dihydroxycarbonylethyl)bicyclo[2.2.1]hept-5-ene-2,3-dicarboxyimide, N-(dihydroxycarbonylpropyl)bicyclo[2.2.1]hept-5-ene-2,3-dicarboxyimide, N-(hydroxycarbonylphenethyl)bicyclo[2.2.1]hept-5-ene-2,3-dicarboxyimide, N-(2-(4-hydroxyphenyl)-1-(hydroxycarbonyl)ethyl)bicyclo[2.2.1]hept-5-ene-2,3-dicarboxyimide, and N-(hydroxycarbonylphenyl)bicyclo[2.2.1]hept-5-ene-2,3-dicarboxyimide; a hydroxyl group-containing cyclic olefin such as 2-(4-hydroxyphenyl)bicyclo[2.2.1]hept-5-ene, 2-methyl-2-(4-hydroxyphenyl)bicyclo[2.2.1]hept-5-ene, 4-(4-hydroxyphenyl)tetracyclo[6.2.1.1^{3,6}.0^{2,7}]dodec-9-ene, 4-methyl-4-(4-hydroxyphenyl)tetracyclo[6.2.1.1^{3,6}.0^{2,7}]dodec-9-ene, 2-hydroxybicyclo[2.2.1]hept-5-ene, 2-hydroxymethylbicyclo[2.2.1]hept-5-ene, 2-hydroxyethylbicyclo[2.2.1]hept-5-ene, 2-methyl-2-hydroxymethylbicyclo[2.2.1]hept-5-ene, 2,3-dihydroxymethylbicyclo[2.2.1]hept-5-ene, 2-(hydroxyethoxycarbonyl)bicyclo[2.2.1]hept-5-ene, 2-methyl-2-(hydroxyethoxycarbonyl)bicyclo[2.2.1]hept-5-ene, 2-(1-hydroxy-1-trifluoromethyl-2,2,2-trifluoroethyl)bicyclo[2.2.1]hept-5-ene, 2-(2-hydroxy-2-trifluoromethyl-3,3,3-trifluoropropyl)bicyclo[2.2.1]hept-5-ene, 3-hydroxytricyclo[5.2.1.0^{2,6}]deca-4,8-diene, 3-hydroxymethyltricyclo[5.2.1.0^{2,6}]deca-4,8-diene, 4-hydroxytetracyclo[6.2.1.1^{3,6}.0^{2,7}]dodec-9-ene, 4-hydroxymethyltetracyclo[6.2.1.1^{3,6}.0^{2,7}]dodec-9-ene, 4,5-dihydroxymethyltetracyclo[6.2.1.1^{3,6}.0^{2,7}]dodec-9-ene, 4-(hydroxyethoxycarbonyl)tetracyclo[6.2.1.1^{3,6}.0^{2,7}]dodec-9-ene, 4-methyl-4-(hydroxyethoxycarbonyl)tetracyclo[6.2.1.1^{3,6}.0^{2,7}]dodec-9-ene, N-(hydroxyethyl)bicyclo[2.2.1]hept-5-ene-2,3-dicarboxyimide, and N-(hydroxyphenyl)bicyclo[2.2.1]hept-5-ene-2,3-dicarboxyimide etc. may be mentioned. Among these as well, from the viewpoint of the adhesion of the obtained resin film becoming higher, carboxy group-containing cyclic olefins are preferable, while 4-hydroxycarbonyltetracyclo[6.2.1.1^{3,6}.0^{2,7}]dodec-9-ene is particularly preferable. These monomers (a) may respectively be used alone or may be used as two types or more combined.

In the cyclic olefin polymer (A1), the ratio of content of the units of the monomer (a) is preferably 10 to 90 mol% with respect to all monomer units, more preferably 20 to 80 mol%, still more preferably 30 to 70 mol%. By making the ratio of content of the units of the monomer (a) the above range, it is possible to further improve the heat resistance of the obtained resin film while making the cyclic olefin polymer (A1) good in solubility in a polar solvent.

Further, the cyclic olefin polymer (A1) used in the present invention may be a copolymer which is obtained by copolymerization of a cyclic olefin monomer which has a protonic polar group (a) and a monomer (b) which can copolymerize with this. As such a copolymerizable monomer, a cyclic olefin monomer which has a polar group other than a protonic polar group (b1), a cyclic olefin monomer which does not have a polar group (b2), and a monomer other than a cyclic olefin (b3) (below, suitably called the "monomer (b1)", "monomer (b2)", and "monomer (b3)") may be mentioned.

As the cyclic olefin monomer which has a polar group other than a protonic polar group (b1), for example, a cyclic olefin which has an N-substituted imide group, ester group, cyano group, acid anhydride group, or halogen atom may be mentioned.

As a cyclic olefin which has an N-substituted imide group, for example, a monomer represented by the following formula (1) may be mentioned.

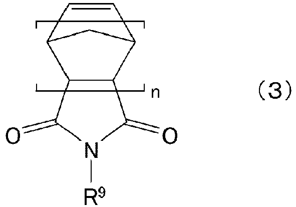

(In the above formula (3), R⁹ indicates a hydrogen atom or alkyl group or aryl group having 1 to 16 carbon atoms. "n" indicates an integer of 1 to 2.)

In the above formula (3), R⁹ is an alkyl group or aryl group having 1 to 16 carbon atoms. As specific examples of the alkyl group, a methyl group, ethyl group, n-propyl group, n-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, and other straight chain alkyl groups; cyclopropyl group, cyclobutyl group, cyclopentyl group, cyclohexyl group, cycloheptyl group, cyclooctyl group, cyclononyl group, cyclodecyl group, cycloundecyl group, cyclododecyl group, norbornyl group, bornyl group, isobornyl group, decahydronaphthyl group, tricyclodecanyl group, adamantyl group, and other cyclic alkyl groups; 2-propyl group, 2-butyl group, 2-methyl-1-propyl group, 2-methyl-2-propyl group, 1-methylbutyl group, 2-methylbutyl group, 1-methylpentyl group, 1-ethylbutyl group, 2-methylhexyl group, 2-ethylhexyl group, 4-methylheptyl group, 1-methylnonyl group, 1-methyltridecyl group, 1-methyltetradecyl group, and other branched alkyl groups; etc. may be mentioned. Further, as specific examples of the aryl group, a phenyl group, benzyl group etc. may be mentioned. Among these as well, due to the more excellent heat resistance and solubility in a polar solvent, an alkyl group and aryl group having 1 to 14 carbon atoms are preferable, while an alkyl group and aryl group having 6 to 10 carbon atoms are more preferable. If the number of carbon atoms is 4 or less, the solubility in a polar solvent is inferior, while if the number of carbon atoms is 17 or more, the heat resistance is inferior. Further, when patterning the resin film, there is the problem that the resin film melts by heat and the patterns to end up disappearing.

As specific examples of the monomer represented by the above general formula (3), bicyclo[2.2.1]hept-5-ene-2,3-dicarboxyimide, N-phenyl-bicyclo[2.2.1]hept-5-ene-2,3-dicarboxyimide, N-methylbicyclo[2.2.1]hept-5-ene-2,3-dicarboxyimide, N-ethylbicyclo[2.2.1]hept-5-ene-2,3-dicarboxyimide, N-propylbicyclo[2.2.1]hept-5-ene-2,3-dicarboxyimide, N-butylbicyclo[2.2.1]hept-5-ene-2,3-dicarboxyimide, N-cyclohexylbicyclo[2.2.1]hept-5-ene-2,3-dicarboxyimide, N-adamantylbicyclo[2.2.1]hept-5-ene-2,3-dicarboxyimide, N-(1-methylbutyl)-bicyclo[2.2.1]hept-5-ene-2,3-dicarboxyimide, N-(2-methylbutyl)-bicyclo[2.2.1]hept-5-ene-2,3-dicarboxyimide, N-(1-methylpentyl)-bicyclo[2.2.1]hept-5-ene-2,3-dicarboxyimide, N-(2-methylpentyl)-bicyclo[2.2.1]hept-5-ene-2,3-dicarboxyimide, N-(1-ethylbutyl)-bicyclo[2.2.1]hept-5-ene-2,3-dicarboxyimide, N-(2-ethylbutyl)-bicyclo[2.2.1]hept-5-ene-2,3-dicarboxyimide, N-(1-methylhexyl)-bicyclo[2.2.1]hept-5-ene-2,3-dicarboxyimide, N-(2-methylhexyl)-bicyclo[2.2.1]hept-5-ene-2,3-dicarboxyimide, N-(3-methylhexyl)-bicyclo[2.2.1]hept-5-ene-2,3-dicarboxyimide, N-(1-butylpentyl)-bicyclo[2.2.1]hept-5-ene-2,3-dicarboxyimide, N-(2-butylpentyl)-bicyclo[2.2.1]hept-5-ene-2,3-dicarboxyimide, N-(1-methylheptyl)-bicyclo[2.2.1]hept-5-ene-2,3-dicarboxyimide, N-(2-methylheptyl)-bicyclo[2.2.1]hept-5-ene-2,3-dicarboxyimide, N-(3-methylheptyl)-bicyclo[2.2.1]hept-5-ene-2,3-dicarboxyimide, N-(4-methylheptyl)-bicyclo[2.2.1]hept-5-ene-2,3-dicarboxyimide, N-(1-ethylhexyl)-bicyclo[2.2.1]hept-5-ene-2,3-dicarboxyimide, N-(2-ethylhexyl)-bicyclo[2.2.1]hept-5-ene-2,3-dicarboxyimide, N-(3-ethylhexyl)-bicyclo[2.2.1]hept-5-ene-2,3-dicarboxyimide, N-(1-propylpentyl)-bicyclo[2.2.1]hept-5-ene-2,3-dicarboxyimide, N-(2-propylpentyl)-bicyclo[2.2.1]hept-5-ene-2,3-dicarboxyimide, N-(1-methyloctyl)-bicyclo[2.2.1]hept-5-ene-2,3-dicarboxyimide, N-(2-methyloctyl)-bicyclo[2.2.1]hept-5-ene-2,3-dicarboxyimide, N-(3-methyloctyl)-bicyclo[2.2.1]hept-5-ene-2,3-dicarboxyimide, N-(4-methyloctyl)-bicyclo[2.2.1]hept-5-ene-2,3-dicarboxyimide, N-(1-ethylheptyl)-bicyclo[2.2.1]hept-5-ene-2,3-dicarboxyimide, N-(2-ethylheptyl)-bicyclo[2.2.1]hept-5-ene-2,3-dicarboxyimide, N-(3-ethylheptyl)-bicyclo[2.2.1]hept-5-ene-2,3-dicarboxyimide, N-(4-ethylheptyl)-bicyclo[2.2.1]hept-5-ene-2,3-dicarboxyimide, N-(1-propylhexyl)-bicyclo[2.2.1]hept-5-ene-2,3-dicarboxyimide, N-(2-propylhexyl)-bicyclo[2.2.1]hept-5-ene-2,3-dicarboxyimide, N-(3-propylhexyl)-bicyclo[2.2.1]hept-5-ene-2,3-dicarboxyimide, N-(1-methylnonyl)-bicyclo[2.2.1]hept-5-ene-2,3-dicarboxyimide, N-(2-methylnonyl)-bicyclo[2.2.1]hept-5-ene-2,3-dicarboxyimide, N-(3-methylnonyl)-bicyclo[2.2.1]hept-5-ene-2,3-dicarboxyimide, N-(4-methylnonyl)-bicyclo[2.2.1]hept-5-ene-2,3-dicarboxyimide, N-(5-methylnonyl)-bicyclo[2.2.1]hept-5-ene-2,3-dicarboxyimide, N-(1-ethyloctyl)-bicyclo[2.2.1]hept-5-ene-2,3-dicarboxyimide, N-(2-ethyloctyl)-bicyclo[2.2.1]hept-5-ene-2,3-dicarboxyimide, N-(3-ethyloctyl)-bicyclo[2.2.1]hept-5-ene-2,3-dicarboxyimide, N-(4-ethyloctyl)-bicyclo[2.2.1]hept-5-ene-2,3-dicarboxyimide, N-(1-methyldecyl)-bicyclo[2.2.1]hept-5-ene-2,3-dicarboxyimide, N-(1-methyldodecyl)-bicyclo[2.2.1]hept-5-ene-2,3-dicarboxyimide, N-(1-methylundecyl)-bicyclo[2.2.1]hept-5-ene-2,3-dicarboxyimide, N-(1-methyldodecyl)-bicyclo[2.2.1]hept-5-ene-2,3-dicarboxyimide, N-(1-methyltridecyl)-bicyclo[2.2.1]hept-5-ene-2,3-dicarboxyimide, N-(1-methyltetradecyl)-bicyclo[2.2.1]hept-5-ene-2,3-dicarboxyimide, N-(1-methylpentadecyl)-bicyclo[2.2.1]hept-5-ene-2,3-dicarboxyimide, N-phenyl-tetracyclo[6.2.1.1^{3,6}.0^{2,7}]dodec-9-ene-4,5-dicarboxyimide, N-(2,4-dimethoxyphenyl)-tetracyclo[6.2.1.1^{3,6}.0^{2,7}]dodec-9-ene-4,5-dicarboxyimide, etc. may be mentioned. Note that, these may respectively be used alone or may be used as two types or more combined.

Note that, the monomer represented by the above general formula (3) can, for example, be obtained by an imidization reaction between a corresponding amine and 5-norbornene-2,3-dicarboxylic acid anhydride. Further, the obtained monomer can be efficiently isolated by separating and refining the reaction solution of the imidization reaction by a known method.

As the cyclic olefin which has an ester group, for example, 2-acetoxybicyclo[2.2.1]hept-5-ene, 2-acetoxymethylbicyclo[2.2.1]hept-5-ene, 2-methoxycarbonylbicyclo[2.2.1]hept-5-ene, 2-ethoxycarbonylbicyclo[2.2.1]hept-5-ene, 2-propoxycarbonylbicyclo[2.2.1]hept-5-ene, 2-butoxycarbonylbicyclo[2.2.1]hept-5-ene, 2-cyclohexyloxycarbonylbicyclo[2.2.1]hept-5-ene, 2-methyl-2-methoxycarbonylbicyclo[2.2.1]hept-5-ene, 2-methyl-2-ethoxycarbonylbicyclo[2.2.1]hept-5-ene, 2-methyl-2-propoxycarbonylbicyclo[2.2.1]hept-5-ene, 2-methyl-2-butoxycarbonylbicyclo[2.2.1]hept-5-ene, 2-methyl-2-cyclohexyloxycarbonylbicyclo[2.2.1]hept-5-ene, 2-(2,2,2-trifluoroethoxycarbonyl)bicyclo[2.2.1]hept-5-ene, 2-methyl-2-(2,2,2-trifluoroethoxycarbonyl)bicyclo[2.2.1]hept-5-ene, 2-methoxycarbonyltricyclo[5.2.1.0^{2,6}]dec-8-ene, 2-ethoxycarbonyltricyclo [5.2.1.0^{2,6}]dec-8-ene, 2-propoxycarbonyltricyclo[5.2.1.0^{2,6}]dec-8-ene, 4-acetoxytetracyclo[6.2.1.1^{3,6}.0^{2,}7]dodec-9-ene, 4-methoxycarbonyltetracyclo[6.2.1.1^{3,6}.0^{2,7}]dodec-9-ene, 4-ethoxycarbonyltetracyclo[6.2.1.1^{3,6}.0^{2,7}]dodec-9-ene, 4-propoxycarbonyltetracyclo[6.2.1.1^{3,6}.0^{2,7}]dodec-9-ene, 4-butoxycarbonyltetracyclo[6.2.1.1^{3,6}.0^{2,7}]dodec-9-ene, 4-methyl-4-methoxycarbonyltetracyclo[6.2.1.1^{3,6}.0^{2,7}]dodec-9-ene, 4-methyl-4-ethoxycarbonyltetracyclo[6.2.1.1^{3,6}.0^{2,7}]dodec-9-ene, 4-methyl-4-propoxycarbonyltetracyclo[6.2.1.1^{3,6}.0^{2,7}]dodec-9-ene, 4-methyl-4-butoxycarbonyltetracyclo[6.2.1.1^{3,6}.0^{2,7}]dodec-9-ene, 4- (2,2,2-trifluoroethoxycarbonyl)tetracyclo[6.2.1.1^{3,6}.0^{2,7}]dodec-9-ene, 4-methyl-4-(2,2,2-trifluoroethoxycarbonyl)tetracyclo[6.2.1.1^{3,6}.0^{2,7}]dodec-9-ene, etc. may be mentioned.

As the cyclic olefin which has a cyano group, for example, 4-cyanotetracyclo[6.2.1.1^{3,6}.0^{2,7}]dodec-9-ene, 4-methyl-4-cyanotetracyclo[6.2.1.1^{3,6}.0^{2,7}]dodec-9-ene, 4,5-dicyanotetracyclo[6.2.1.1^{3,6}.0^{2,7}]dodec-9-ene, 2-cyanobicyclo[2.2.1]hept-5-ene, 2-methyl-2-cyanobicyclo[2.2.1]hept-5-ene, 2,3-dicyanobicyclo[2.2.1]hept-5-ene, etc. may be mentioned.

As the cyclic olefin which has an acid anhydride group, for example, tetracyclo [6.2.1.1^{3,6}.0^{2,7}]dodec-9-ene-4,5-dicarboxylic anhydride, bicyclo[2.2.1]hept-5-ene-2,3-dicarboxylic anhydride, 2-carboxymethyl-2-hydroxycarbonylbicyclo[2.2.1]hept-5-ene anhydride, etc. may be mentioned.

As the cyclic olefin which has a halogen atom, for example, 2-chlorobicyclo[2.2.1]hept-5-ene, 2-chloromethylbicyclo[2.2.1]hept-5-ene, 2-(chlorophenyl)bicyclo[2.2.1]hept-5-ene, 4-chlorotetracyclo[6.2.1.1^{3,6}.0^{2,7}]dodec-9-ene, 4-methyl-4-chlorotetracyclo[6.2.1.1^{3,6}.0^{2,7}]dodec-9-ene, etc. may be mentioned.

These monomers (b1) may respectively be used alone or may be used as two types or more combined.

As the cyclic olefin monomer which does not have a polar group (b2), bicyclo[2.2.1]hept-2-ene (also called "norbornene"), 5-ethylbicyclo[2.2.1]hept-2-ene, 5-butyl-bicyclo[2.2.1]hept-2-ene, 5-ethylidene-bicyclo[2.2.1]hept-2-ene, 5-methylidene-bicyclo[2.2.1]hept-2-ene, 5-vinyl-bicyclo[2.2.1]hept-2-ene, tricyclo[5.2.1.0^{2,6}]deca-3,8-diene (common name: dicyclopentadiene), tetracyclo[10.2.1.0^{2,11}.0^{4,9}]pentadec-4,6,8,13-tetraene, tetracyclo[6.2.1.1^{3,6}.0^{2,7}]dodec-4-ene (also called "tetracyclododecene"), 9-methyl-tetracyclo[6.2.1.1^{3,6}.0^{2,7}]dodec-4-ene, 9-ethyl-tetracyclo[6.2.1.1^{3,6}.0^{2,7}]dodec-4-ene, 9-methylidene-tetracyclo[6.2.1.1^{3,6}.0^{2,7}]dodec-4-ene, 9-ethylidene-tetracyclo[6.2.1.1^{3,6}.0^{2,7}]dodec-4-ene, 9-vinyl-tetracyclo[6.2.1.1^{3,6}.0^{2,7}]dodec-4-ene, 9-propenyl-tetracyclo[6.2.1.1^{3,6}.0^{2,7}]dodec-4-ene, pentacyclo[9.2.1.1^{3,9}.0^{2,10}.0^{4,8}]pentadeca-5,12-diene, cyclobutene, cyclopentene, cyclopentadiene, cyclohexene, cycloheptene, cyclooctene, cyclooctadiene, indene, 3a,5,6,7a-tetrahydro-4,7-methano-1H-indene, 9-phenyl-tetracyclo[6.2.1.1^{3,6}.0^{2,7}]dodec-4-ene, tetracyclo[9.2.1.0^{2,10}.0^{3,8}]tetradec-3,5,7,12-tetraene, pentacyclo[9.2.1.1^{3,9}.0^{2,10}.0^{4,8}]pentadec-12-ene, etc. may be mentioned.

These monomers (b2) may respectively be used alone or may be used as two types or more combined.

As specific examples of the monomer other than a cyclic olefin (b3), ethylene; propylene, 1-butene, 1-pentene, 1-hexene, 3-methyl-1-butene, 3-methyl-1-pentene, 3-ethyl-1-pentene, 4-methyl-1-pentene, 4-methyl-1-hexene, 4,4-dimethyl-1-hexene, 4,4-dimethyl-1-pentene, 4-ethyl-1-hexene, 3-ethyl-1-hexene, 1-octene, 1-decene, 1-dodecene, 1-tetradecene, 1-hexadecene, 1-octadecene, 1-eicosene, and other C₂ to C₂₀ α-olefins; 1,4-hexadiene, 1,5-hexadiene, 4-methyl-1,4-hexadiene, 5-methyl-1,4-hexadiene, 1,7-octadiene, and other nonconjugated dienes and their derivatives; etc. may be mentioned. Among these as well, α-olefin is preferable.

These monomers (b3) may respectively be used alone or may be used as two types or more combined.

Among these monomers (b1) to (b3) as well, from the viewpoint of the effect of the present invention becoming more remarkable, a cyclic olefin monomer which has a polar group other than a protonic polar group (b1) is preferable, while a cyclic olefin which has an N-substituted imide group is particularly preferable.

In the cyclic olefin polymer (A1), the ratio of content of units of the copolymerizable monomer (b) is preferably 10 to 90 mol% with respect to the total monomer units, more preferably 20 to 80 mol%, still more preferably 30 to 70 mol%. By making the ratio of content of the units of the monomer (b) the above range, it is possible to further improve the heat resistance of the obtained resin film while making the cyclic olefin polymer (A1) good in solubility in a polar solvent.

Note that, in the present invention, it is also possible to introduce a protonic group in a cyclic olefin-based polymer which does not have a protonic polar group utilizing a known modifying agent so as to obtain the cyclic olefin polymer (A1).

The polymer which does not have a protonic polar group can be obtained by polymerizing at least one of the above-mentioned monomers (b1) and (b2) and, in accordance with need, a monomer (b3) in any combination.

As a modifying agent for introduction of a protonic polar group, usually a compound which has a protonic polar group and a reactive carbon-carbon unsaturated bond in a single molecule is used.

As specific examples of this compound, acrylic acid, methacrylic acid, angelic acid, tiglic acid, oleic acid, elaidic acid, erucic acid, brassidic acid, maleic acid, fumaric acid, citraconic acid, mesaconic acid, itaconic acid, atropic acid, cinnamic acid, or other unsaturated carboxylic acid; allyl alcohol, methylvinyl methanol, crotyl alcohol, methacryl alcohol, 1-phenylethen-1-ol, 2-propen-1-ol, 3-buten-1-ol, 3-buten-2-ol, 3-methyl-3-buten-1-ol, 3-methyl-2-buten-1-ol, 2-methyl-3-buten-2-ol, 2-methyl-3-buten-1-ol, 4-penten-1-ol, 4-methyl-4-penten-1-ol, 2-hexen-1-ol, or other unsaturated alcohol; etc. may be mentioned.

The modification reaction of a polymer in which these modifying agents are used may be performed in accordance with an ordinary method and is usually performed in the presence of a radical generator.

Note that, the cyclic olefin polymer (A1) used in the present invention may be a ring-opened polymer obtained by ring-opening polymerization of the above-mentioned monomers or may be an addition polymer obtained by addition polymerization of the above-mentioned monomers, but from the viewpoint of the effect of the present invention becoming more remarkable, a ring-opened polymer is preferable.

A ring-opened polymer can be produced by ring-opening methathesis polymerization of a cyclic olefin monomer which has a protonic polar group (a) and a copolymerizable monomer (b) used according to need in the presence of a methathesis reaction catalyst. As the method of production, for example, the method described in International Publication No. 2010/110323A, [0039] to [0079], etc. can be used.

Further, when the cyclic olefin polymer (A1) used in the present invention is a ring-opened polymer, it is preferable to further perform a hydrogenation reaction and obtain a hydrogenated product in which the carbon-carbon double bonds which are contained in the main chain are hydrogenated. When the cyclic olefin polymer (A1) is a hydrogenated product, the ratio of the hydrogenated carbon-carbon double bonds (hydrogenation rate) is usually 50% or more. From the viewpoint of the heat resistance, 70% or more is preferable, 90% or more is more preferable, and 95% or more is furthermore preferable.

Further, the acrylic resin (A2) used in the present invention is not particularly limited, but a homopolymer or copolymer having at least one of a carboxylic acid which has an acryl group, carboxylic anhydride which has an acryl group, epoxy group-containing acrylate compound and oxetane group-containing acrylate compound as an essential ingredient is preferable.

As specific examples of the carboxylic acid which has an acryl group, (meth)acrylic acid (meaning acrylic acid and/or methacrylic acid, below, same for methyl(meth)acrylate etc.), crotonic acid, maleic acid, fumaric acid, citraconic acid, mesaconic acid, glutaconic acid, phthalic acid mono-(2-((meth)acryloyloxy)ethyl), N-(carboxyphenyl)maleimide, N-(carboxyphenyl)(meth)acrylamide, etc. may be mentioned.

As specific examples of the carboxylic anhydride which has an acryl group, maleic anhydride, citraconic anhydride, etc. may be mentioned.

As specific examples of the epoxy group-containing acrylate compound, glycidyl acrylate, glycidyl methacrylate, glycidyl α-ethyl acrylate, glycidyl α-n-propyl acrylate, glycidyl α-n-butyl acrylate, 3,4-epoxybutyl acrylate, 3,4-epoxybutyl methacrylate, 6,7-epoxyheptyl acrylate, 6,7-epoxyheptyl methacrylate, 6,7-epoxyheptyl α-ethyl acrylate, 3,4-epoxycyclohexylmethyl acrylate, 3,4-epoxycyclohexylmethyl methacrylate, etc. may be mentioned.

As specific examples of the oxetane group-containing acrylate compound, (3-methyloxetan-3-yl)methyl(meth)acrylate, (3-ethyloxetan-3-yl)methyl(meth)acrylate, (3-methyloxetan-3-yl)ethyl(meth)acrylate, (3-ethyloxetan-3-yl)ethyl(meth)acrylate, (3-chloromethyloxetan-3-yl)methyl (meth)acrylate, (oxetan-2-yl)methyl(meth)acrylate, (2-methyloxetan-2-yl)methyl(meth)acrylate, (2-ethyloxetan-2-yl)methyl(meth)acrylate, (1-methyl-1-oxetanyl-2-phenyl)-3-(meth)acrylate, (1-methyl-1-oxetanyl)-2-trifluoromethyl-3-(meth)acrylate, and (1-methyl-1-oxetanyl)-4-trifluoromethyl-2-(meth)acrylate, etc. may be mentioned.

Among these as well, (meth)acrylic acid, maleic anhydride, glycidyl (meth)acrylate, 6,7-epoxyheptyl methacrylate, etc. are preferable.

The acrylic resin (A2) may also be a copolymer of at least one compound which is selected from unsaturated carboxylic acids, unsaturated carboxylic anhydrides, and epoxy group-containing unsaturated compounds, and other acrylate-based monomers or copolymerizable monomers other than acrylates.

As other acrylate-based monomers, methyl(meth)acrylate, ethyl (meth)acrylate, propyl(meth)acrylate, isopropyl(meth)acrylate, butyl (meth)acrylate, isobutyl(meth)acrylate, t-butyl(meth)acrylate, amyl (meth)acrylate, isoamyl(meth)acrylate, hexyl(meth)acrylate, heptyl (meth)acrylate, octyl(meth)acrylate, isooctyl(meth)acrylate, ethylhexyl(meth)acrylate, nonyl(meth)acrylate, decyl(meth)acrylate, isodecyl(meth)acrylate, undecyl(meth)acrylate, dodecyl(meth)acrylate, lauryl(meth)acrylate, stearyl(meth)acrylate, isostearyl(meth)acrylate, and other alkyl(meth)acrylates; hydroxyethyl(meth)acrylate, 2-hydroxypropyl(meth)acrylate, 3-hydroxypropyl(meth)acrylate, 2-hydroxybutyl(meth)acrylate, 3-hydroxybutyl(meth)acrylate, 4-hydroxybutyl(meth)acrylate, and other hydroxyalkyl(meth)acrylates; phenoxyethyl(meth)acrylate, 2-hydroxy-3-phenoxypropyl(meth)acrylate, and other phenoxyalkyl(meth)acrylates; 2-methoxyethyl(meth)acrylate, 2-ethoxyethyl(meth)acrylate, 2-propoxyethyl(meth)acrylate, 2-butoxyethyl(meth)acrylate, 2-methoxybutyl(meth)acrylate, and other alkoxyalkyl(meth)acrylates; polyethylene glycol mono(meth)acrylate, ethoxydiethylene glycol(meth)acrylate, methoxypolyethylene glycol (meth)acrylate, phenoxypolyethylene glycol(meth)acrylate, nonyl phenoxypolyethylene glycol(meth)acrylate, polypropylene glycol mono(meth)acrylate, methoxypolypropylene glycol(meth)acrylate, ethoxypolypropylene glycol(meth)acrylate, nonylphenoxypolypropylene glycol(meth)acrylate, and other polyalkylene glycol(meth)acrylates; cyclohexyl(meth)acrylate, 2-methylcyclohexyl(meth)acrylate, 4-butylcyclohexyl(meth)acrylate, 1-adamantyl(meth)acrylate, 2-methyl-2-adamantyl(meth)acrylate, 2-ethyl-2-adamantyl(meth)acrylate, tricyclo[5.2.1.0^{2,6}]decan-8-yl(meth)acrylate, tricyclo[5.2.1.0^{2,6}]-3-decen-8-yl(meth)acrylate, tricyclo[5.2.1.0^{2,6}]-3-decen-9-yl (meth)acrylate, bornyl(meth)acrylate, isobornyl(meth)acrylate, and other cycloalkyl(meth)acrylates; phenyl(meth)acrylate, naphthyl (meth)acrylate, biphenyl(meth)acrylate, benzyl(meth)acrylate, tetrahydrofurfuryl(meth)acrylate, 5-tetrahydrofurfuryl oxycarbonylpentyl(meth)acrylate, vinyl(meth)acrylate, allyl (meth)acrylate, 2-(2-vinyloxyethoxy)ethyl(meth)acrylate, 2-[tricyclo[5.2.1.0^{2,6}]decan-8-yloxy]ethyl(meth)acrylate, 2-[tricyclo[5.2.1.0^{2,6}]-3-decen-8-yloxy]ethyl(meth)acrylate, 2-[tricyclo[5.2.1.0^{2,6}]-3-decen-9-yloxy]ethyl(meth)acrylate, γ-butyrolactone(meth)acrylate, maleimide, N-methylmaleimide, N-ethylmaleimide, N-butylmaleimide, N-cyclohexylmaleimide, N-benzylmaleimide, N-phenylmaleimide, N-(2,6-diethylphenyl)maleimide, N-(4-acetylphenyl)maleimide, N-(4-hydroxyphenyl)maleimide, N-(4-acetoxyphenyl)maleimide, N-(4-dimethylamino-3,5-dinitrophenyl)maleimide, N-(1-anilinonaphthyl-4)maleimide, N-[4-(2-benzooxazolyl)phenyl]maleimide, N-(9-acridinyl)maleimide, etc. may be mentioned.

Among these as well, methyl(meth)acrylate, butyl(meth)acrylate, cyclohexyl(meth)acrylate, 2-methylcyclohexyl(meth)acrylate, benzyl (meth)acrylate, tricyclo[5.2.1.0^{2,6}]decan-8-yl(meth)acrylate, N-phenylmaleimide, N-cyclohexylmaleimide, etc. are preferable.

The copolymerizable monomer other than acrylate is not particularly limited so long as a compound which can copolymerize with the above carboxylic acid which has an acryl group, carboxylic anhydride which has an acryl group, epoxy group-containing acrylate compound, but, for example, vinylbenzylmethyl ether, vinylglycidyl ether, styrene, α-methylstyrene, vinyltoluene, indene, vinylnaphthalene, vinylbiphenyl, chlorostyrene, bromostyrene, chloromethylstyrene, p-tert-butoxystyrene, p-hydroxystyrene, p-hydroxy-α-methylstyrene, p-acetoxystyrene, p-carboxystyrene, 4-hydroxyphenylvinylketone, acrylonitrile, methacrylonitrile, (meth)acrylamide, 1,2-epoxy-4-vinylcyclohexane, isobutene, norbornene, butadiene, isoprene, and other radical polymerizable compounds may be mentioned.

These compounds may respectively be used alone or may be used as two types or more combined.

The polymerization method of the above monomer may be an ordinary method. For example, the suspension polymerization method, the emulsion polymerization method, the solution polymerization method, etc. may be employed.

The polyimide or its precursor (A3) used in the present invention is obtained by reacting a tetracarboxylic dianhydride and diamine, and it may be one obtained by further heat treating the result, if necessary. As the precursor for obtaining the polyimide, a polyamic acid, polyamic acid ester, polyisoimide, polyamic acid sulfonamide, etc. may be mentioned.

The polyimide or its precursor (A3) used in the present invention is synthesized by a known method. That is, it is synthesized by a known method such as selectively combining tetracarboxylic dianhydride and a diamine and reacting these in N-methyl-2-pyrrolidone, N,N-dimethylacetoamide, N,N-dimethylformamide, dimethylsulfoxide, hexamethylphosphoric triamide, γ-butyrolactone, cyclopentanone, or other polar solvent.

When excessively using a diamine for polymerization, it is possible to make a carboxylic anhydride react with the end amino group of the produced polyimide (A3) so as to protect the end amino group. Further, when excessively using tetracarboxylic dianhydride for polymerization, it is possible to make an amine compound react with the end acid anhydride group of the produced polyimide (A3) so as to protect the end acid anhydride group.

As examples of such carboxylic anhydrides, phthalic anhydride, trimellitic anhydride, maleic anhydride, naphthalic anhydride, hydrogenated phthalic anhydride, methyl-5-norbornene-2,3-dicarboxylic anhydride, itaconic anhydride, tetrahydrophthalic acid anhydride, etc. may be mentioned, while as examples of amine compounds, aniline, 2-hydroxyaniline, 3-hydroxyaniline, 4-hydroxyaniline, 2-ethynylaniline, 3-ethynylaniline, 4-ethynylaniline, etc. may be mentioned.

The polybenzoxazole or its precursor (A4) used in the present invention is obtained by reacting a bis(ortho-aminophenol) compound, and a dicarboxylic acid, dicarboxylic acid ester and carboxylic acid dichloride, and it may be one obtained by further heat treating the result, if necessary.

The polysiloxane (A5) used in the present invention is not particularly limited, but preferably a polymer which is obtained by mixing and reacting one or more types of organosilane represented by the following formula (4) may be mentioned.

(R¹⁰)ₚ-Si-(OR¹¹)₄₋ₚ (4)

In the above formula (4), R¹⁰ is a hydrogen atom, alkyl group having 1 to 10 carbon atoms, alkenyl group having 2 to 10 carbon atoms, aryl group having 6 to 15 carbon atoms. The plurality of R¹⁰ may be the same or different. Note that, these alkyl groups, alkenyl groups, and aryl groups may all have substituents. Further, they may be nonsubstituted groups which do not have substituents and may be selected in accordance with the properties of the composition. As specific examples of the alkyl group, a methyl group, ethyl group, n-propyl group, isopropyl group, n-butyl group, t-butyl group, n-hexyl group, n-decyl group, trifluoromethyl group, 2,2,2-trifluoroethyl group, 3,3,3-trifluoropropyl group, 3-glycidoxypropyl group, 2-(3,4-epoxy cyclohexyl)ethyl group, 3-aminopropyl group, 3-mercaptopropyl group, and 3-isocyanatepropyl group may be mentioned. As specific examples of the alkenyl group, a vinyl group, 3-acryloxypropyl group, and 3-methacryloxypropyl group may be mentioned. As specific example of the aryl group, a phenyl group, tolyl group, p-hydroxyphenyl group, 1-(p-hydroxyphenyl)ethyl group, 2-(p-hydroxyphenyl)ethyl group, 4-hydroxy-5-(p-hydroxyphenylcarbonyloxy)pentyl group, and naphthyl group may be mentioned.

Further, in the above general formula (4), R¹¹ is a hydrogen atom, alkyl group having 1 to 6 carbon atoms, acyl group having 1 to 6 carbon atoms, aryl group having 6 to 15 carbon atoms, where the plurality of R¹¹ may be the same or different. Note that, these alkyl groups and acyl groups may all have substituents. Further, they may be nonsubstituted groups which do not have substituents and may be selected in accordance with the properties of the composition. As specific examples of the alkyl group, a methyl group, ethyl group, n-propyl group, isopropyl group, and n-butyl group may be mentioned. As a specific example of the acyl group, an acetyl group may be mentioned. As a specific example of an aryl group, a phenyl group may be mentioned.

Furthermore, in the above general formula (4), "p" is an integer of 0 to 3. When p=0, the compound becomes tetrafunctional silane, when p=1, it becomes trifunctional silane, when p=2, it becomes bifunctional silane, and when p=3, it becomes monofunctional silane.

As specific examples of an organosilane represented by the above general formula (4), tetramethoxysilane, tetraethoxysilane, tetraacetoxysilane, tetraphenoxysilane, or other tetrafunctional silanes; methyltrimethoxysilane, methyltriethoxysilane, methyltriisopropoxysilane, methyltri-n-butoxysilane, ethyltrimethoxysilane, ethyltriethoxysilane, ethyltriisopropoxysilane, ethyltri-n-butoxysilane, n-propyltrimethoxysilane, n-propyltriethoxysilane, n-butyltrimethoxysilane, n-butyltriethoxysilane, n-hexyltrimethoxysilane, n-hexyltriethoxysilane, decyltrimethoxysilane, vinyltrimethoxysilane, vinyltriethoxysilane, 3-methacryloxypropyltrimethoxysilane, 3-methacryloxypropyltriethoxysilane, 3-acryloxypropyltrimethoxysilane, phenyltrimethoxysilane, phenyltriethoxysilane, p-hydroxyphenyltrimethoxysilane, 1-(p-hydroxyphenyl)ethyltrimethoxysilane, 2-(p-hydroxyphenyl)ethyltrimethoxysilane, 4-hydroxy-5-(p-hydroxyphenylcarbonyloxy)pentyltrimethoxysilane, trifluoromethyltrimethoxysilane, trifluoromethyltriethoxysilane, 3,3,3-trifluoropropyltrimethoxysilane, 3-aminopropyltrimethoxysilane, 3-aminopropyltriethoxysilane, 3-glycidoxypropyltrimethoxysilane, 2-(3,4-epoxy cyclohexyl)ethyltrimethoxysilane, 3-mercaptopropyltrimethoxysilane, or other trifunctional silanes; dimethyldimethoxysilane, dimethyldiethoxysilane, dimethyldiacetoxysilane, di-n-butyldimethoxysilane, diphenyldimethoxysilane, or other bifunctional silanes; trimethylmethoxysilane, tri-n-butylethoxysilane, or other monofunctional silanes; may be mentioned.

Among these organosilanes, from the viewpoint of the crack resistance or hardness of the obtained resin film, trifunctional silanes are preferably used. These organosilanes may be used alone or may be used as two types or more combined.

The polysiloxane (A5) used in the present invention is obtained by the hydrolysis or partial condensation of the above-mentioned organosilanes. For the hydrolysis and partial condensation, general methods can be used. For example, a solvent, water, and according to need a catalyst are added to the mixture and heated and stirred. During stirring, in accordance with need, distillation may be used to distill off the hydrolysis byproducts (methanol or other alcohol) or condensation byproduct (water).

The phenol resin (A6) used in the present invention is obtained, for example, by reacting a phenol compound, and an aldehyde, dimethylol compound, dialkoxymethyl compound, dihalomethyl compound in the presence of an acid catalyst.

The binder resin (A) used in the present invention has a weight average molecular weight (Mw) of usually 1,000 to 1,000,000, preferably 1,500 to 100,000, more preferably 2,000 to 30,000 in range.

Further, the binder resin (A) has a molecular weight distribution of a weight average molecular weight/number average molecular weight (Mw/Mn) ratio of usually 4 or less, preferably 3 or less, more preferably 2.5 or less.

The weight average molecular weight (Mw) and molecular weight distribution (Mw/Mn) of the binder resin (A) are values which are found by gel permeation chromatography (GPC) using tetrahydrofuran and other solvents as eluents and as values converted to polystyrene.

### (Aromatic Compound (B) Represented by General Formula (1))

The resin composition of the present invention contains an aromatic compound (B) represented by the following general formula (1) (below, suitably abbreviated as the "aromatic compound (B)"). The aromatic compound (B) is believed to react with the cross-linking agent (C) to raise the cross-linking degree of the resin composition of the present invention and enhance the waterproofness and solvent resistance. 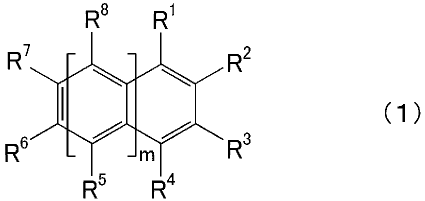 where in the general formula (1), each of R¹ to R⁸ respectively independently is hydrogen atom, hydroxyl group, carboxyl group, substituted or unsubstituted aliphatic hydrocarbon group having 1 to 12 carbon atoms, or substituted or unsubstituted aromatic hydrocarbon group having 6 to 12 carbon atoms, "m" is an integer of 0 to 2, when "m" is 0, at least two of R¹ to R⁴, R⁶, and R⁷ are hydroxyl group, when "m" is 1 or 2, at least two of R¹ to R⁸ are hydroxyl group, and, when "m" is 2 or more, regardless of the structure represented by general formula (1), three or more benzene rings present may be joined with each other at any positions.

Note that, when each of R¹ to R⁸ is a substituted or unsubstituted aliphatic hydrocarbon group having 1 to 12 carbon atoms or substituted or unsubstituted aromatic hydrocarbon group having 6 to 12 carbon atoms, the substituent is not particularly limited, but hydroxyl group, carboxyl group, halogen atom, etc. may be mentioned.

In the above general formula (1), each of R¹ to R⁸ is preferably hydrogen atom, hydroxyl group, or aliphatic hydrocarbon group having 1 to 6 carbon atoms.

In the above general formula (1), further, "m" is preferably 0. That is, as the aromatic compound (B), a compound represented by the following general formula (2) is more preferable: 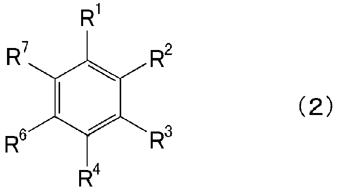 where in the general formula (2), R¹ to R⁴, R⁶, and R⁷ are the same as in the above general formula (1) and at least two of R¹ to R⁴, R⁶, and R⁷ are hydroxyl group.

In the compounds represented by the above general formula (2) as well, from the viewpoint of enabling the action and effects of the present invention to be made much more remarkable, a compound wherein two of R¹ to R⁴, R⁶, and R⁷ are hydroxyl group, one of R¹ to R⁴, R⁶, and R⁷ is an aliphatic hydrocarbon group having 1 to 12 carbon atoms, and the remainder are hydrogen atom, and a compound where three of R¹ to R⁴, R⁶, and R⁷ are hydroxyl group and the remainder are hydrogen atom are more preferable. Further, in the above general formula (2), the positions of the two or more included hydroxyl group on the benzene ring are not particularly limited, but from the viewpoint of being able to make the action and effects of the present invention much more remarkable, for example, when there are two hydroxyl groups, compounds where hydroxyl groups are present at the meta-position (that is, resorcinols) are preferable and, further, when there are three hydroxyl groups, compounds where hydroxyl groups are present at the 1-position, 3-position, and 5-position (that is, 1,3,5-trihydroxybenzenes) are preferable. The positions of these hydroxyl groups on the benzene ring are believed to give resistance to the influence of the steric effects of the hydroxyl groups and to enable an efficient cross-linking reaction to proceed.

Further, as the aromatic compound (B) used in the present invention, compounds with a molecular weight of 90 to 500 in range are preferable and compounds of 100 to 300 in range are more preferable.

As specific examples of the aromatic compound (B), cathecols such as catechol, 3-methyl catechol, 3-ethyl catechol, 4-methyl catechol, 4-ethyl catechol, 2-isopentyl pyrocatechol, 2,3-dimethyl catechol, 2,3-diethyl catechol, 2,3-diisopentyl catechol, 2-methyl 3-octyl catechol, 2-butyl 3-tert-butyl catechol, 2,3-dibromocatechol, 2,4-diisopropyl catechol, 2-pentyl 4-octyl catechol, 2,4-dibromocatechol, 2,5-diethyl catechol, 2,5-di-tert-pentyl catechol, 2-butyl 5-bromocatechol, 2,5-dicyclocatechol, and 3,4,6-triisopropyl catechol;
resorcinols such as resorcinol, 2-methyl resorcinol, 2-butyl resorcinol, 2-octyl resorcinol, 2,4-dimethyl resorcinol, 2,4-diethyl resorcinol, 2,4-dipentyl resorcinol, 2,4-diisopropyl resorcinol, 2,5-dimethyl resorcinol, 2-methyl 5-tert-butyl resorcinol, 2,5-dioctyl resorcinol, 4,6-dimethyl resorcinol, 4,6-dibutyl resorcinol, 4,6-dicycloresorcinol, 4,6-dibromoresorcinol, 4-chloro 6-methyl resorcinol, and 2,4,5-trimethyl resorcinol;
p-hydroquinones such as p-hydroquinone, 2-methyl p-hydroquinone, 2-ethyl p-hydroquinone, 2-hexyl p-hydroquinone, 2-isopropyl p-hydroquinone, 2,5-dimethyl p-hydroquinone, 2,5-diethyl p-hydroquinone, 2,5-di-tert-butyl p-hydroquinone, 2,5-dioctyl p-hydroquinone, 2,3-dimethyl p-hydroquinone, 2,6-diethyl p-hydroquinone, 2,4-dipentyl p-hydroquinone, 2,5-dichloro p-hydroquinone, 2,5-dibromo p-hydroquinone, 2-methyl 5-ethyl p-hydroquinone, and 2-methyl 5-tert-butyl p-hydroquinone;
phloroglucinols such as phloroglucinol, 2-methyl phloroglucinol, 2,4-dibutyl phloroglucinol, 2,4,6-tribromophloroglucinol, and 2,4,6-trichlorophloroglucinol;
1,2,3-trihydroxybenzenes such as 1,2,3-trihydroxybenzene, 1,2,3-trihydroxy 4-methyl benzene, 1,2,3-trihydroxy 5-butyl benzene, 1,2,3-trihydroxy 4,6-dibromobenzene, and 1,2,3-trihydroxy 4,5,6-trimethyl benzene;
1,2,4-trihydroxybenzenes such as 1,2,4-trihydroxybenzene, 1,2,4-trihydroxy 5-methyl benzene, 1,2,4-trihydroxy 3,5-dimethyl benzene, and 1,2,4-trihydroxy 3,5,6-tribromobenzene;
dihydroxynaphthalenes such as 1,2-dihydroxynaphthalene, 1,3-dihydroxynaphthalene, 2,3-dihydroxynaphthalene, 1,6-dihydroxynaphthalene, 2,6-dihydroxynaphthalene, 1,7-dihydroxynaphthalene, and 2,7-dihydroxynaphthalene;
hydroxyanthracenes such as 1,4-dihydroxyanthracene and 9,10-dihydroxyanthracene;
etc. may be mentioned.

In the resin composition of the present invention, the content of the aromatic compound (B) is preferably 0.01 to 30 parts by weight with respect to 100 parts by weight of the binder resin (A), more preferably 0.1 to 20 parts by weight, still more preferably 0.5 to 15 parts by weight, particularly preferably 2 to 10 parts by weight. By making the content of the aromatic compound (B) this range, the resin film obtained using the resin composition of the present invention can be given a higher balance of heat resistance, waterproofness, thermal shock resistance, and solvent resistance.

### (Cross-Linking Agent (C))

The resin composition of the present invention contains the cross-linking agent (C) in addition to the binder resin (A) and aromatic compound (B). As the cross-linking agent (C), one forming a cross-linked structure between cross-linking agent molecules due to heating or one reacting with the binder resin (A) and forming a cross-linked structure between resin molecules, specifically a compound having two or more reactive groups, may be mentioned. Further, as mentioned above, the cross-linking agent (C) is believed to react with the aromatic compound (B) to raise the cross-linking degree of the resin composition of the present invention.

The compound having reactive groups is not particularly limited, but for example an epoxy group-containing cross-linking agent, alkoxymethyl group-containing cross-linking agent, methylol group-containing cross-linking agent, oxetane group-containing cross-linking agent, isocyanate group-containing cross-linking agent, block isocyanate group-containing cross-linking agent, oxazoline group-containing cross-linking agent, maleimide group-containing cross-linking agent, (meth)acrylate group-containing cross-linking agent, etc. may be mentioned. Among these as well, an epoxy group-containing cross-linking agent is preferable.

As specific examples of the epoxy group-containing cross-linking agent, for example, an epoxy compound having an alicyclic structure such as an epoxy compound having dicyclopentadiene as a skeleton (product name "HP-7200", made by DIC), a 1,2-epoxy-4-(2-oxiranyl)cyclohexane adduct of 2,2-bis(hydroxymethyl)1-butanol (15-functional alicyclic epoxy resin having a cyclohexane skeleton and terminal epoxy group, product name "EHPE3150", made by Daicel Chemical Industries), an epoxylated 3-cyclohexene-1,2-dicarboxylic acid bis(3-cyclohexenylmethyl)-modified ε-caprolactone (aliphatic cyclic trifunctional epoxy resin, product name "Epolide GT301", made by Daicel Chemical Industries), epoxylated butanetetracarboxylic acid tetrakis(3-cyclohexenylmethyl)-modified ε-caprolactone (aliphatic cyclic tetrafunctional epoxy resin, product name "Epolide GT401", made by Daicel Chemical Industries), 3,4-epoxycyclohexenylmethyl-3',4'-epoxycyclohexenecarboxylate (product names "Celloxide 2021" and "Celloxide 2021P", made by Daicel Chemical Industries), ε-caprolactone-modified 3',4'-epoxycyclohexylmethyl-3,4-epoxycyclohexane carboxylate (product name "Celloxide 2081", made by Daicel Chemical Industries), 1,2:8,9-diepoxylimonene (product name "Celloxide 3000", made by Daicel Chemical Industries), and 2-(3,4-epoxycyclohexyl)ethyltrimethoxysilane (product name "Z-6043", made by Toray-Dow Corning);
an epoxy compound not having an alicyclic structure such as a bisphenol A type epoxy compound (product names "jER 825", "jER 827", "jER 828", and "jER YL980", made by Mitsubishi Chemical and product names "EPICLON 840" and "EPICLON 850", made by DIC), a bisphenol F type epoxy compound (product names "jER 806", "jER 807", and "jER YL983U", made by Mitsubishi Chemical, and product names "EPICLON 830" and "EPICLON 835", made by DIC), hydrated bisphenol A type epoxy compound (product names "jER YX8000" and "jER YX8034", made by Mitsubishi Chemical, product name "ST-3000", made by Nippon Steel & Sumitomo Metal, product name "Rikaresin HBE-100", made by New Japan Chemical, and product name "Epolite 4000", made by Kyoei Kagaku Kogyou), a long chain bisphenol A type epoxy resin (product names "EXA-4816", "EXA-4850-150", and "EXA-4850-1000", made by DIC), EO-modified bisphenol A type epoxy compound (product names "Adeka Resin EP-4000L" and "Adeka Resin EP-4010L", made by Adeka), phenol novolac type polyfunctional epoxy compound (product name "jER 152", made by Mitsubishi Chemical), a polyfunctional epoxy compound having a naphthalene structure such as 1,6-bis(2,3-epoxy propan-1-yloxy)naphthalene (product name "HP-4032D", made by DIC), dicyclopentadiene dimethanol diglycidyl ether (product names "Adeka Resin EP-4000L" and "Adeka Resin EP-4088L", made by Adeka), glycidyl amine type epoxy resin (product name "product name "jER630", made by Mitsubishi Chemical, product names "TETRAD-C" and "TETRAD-X", made by Mitsubishi Gas Chemical), chain type alkylpolyfunctional epoxy compound (product name "SR-TMP", made by Sakamoto Yakuhin Kogyo), polyfunctional epoxy polybutadiene (product name "Epolide PB3600", made by Daicel Chemical Industries), (product name "Epolide PB4700", made by Daicel Chemical Industries), a glycidyl polyether compound of glycerin (product name "SR-GLG", made by Sakamoto Yakuhin Kogyo), a diglycerin polyglycidyl ether compound (product name "SR-DGE", made by Sakamoto Yakuhin Kogyo), polyglycerin polyglycidyl ether compound (product name "SR-4GL", made by Sakamoto Yakuhin Kogyo), and γ-glycidoxypropyltrimethylsilane (product name "Z6040", made by Dow Corning Toray); etc. may be mentioned.

Further, as the alkoxymethyl group-containing cross-linking agent may be a compound containing two or more alkoxymethyl groups, and it is not particularly limited, but a phenol compound having two or more alkoxymethyl groups directly bonded to an aromatic ring, and a melamine compound with an amino group substituted by two or more alkoxymethyl groups may be mentioned.

For the examples of the compound containing two or more alkoxymethyl groups in its molecule, as a phenol compound having two or more alkoxymethyl groups directly bonded to an aromatic ring, for example, dimethoxymethyl substituted phenol compound such as 2,6-dimethoxymethyl-4-t-butyl phenol and 2,6-dimethoxymethyl-p-cresol, tetramethoxymethyl substituted biphenyl compound such as 3,3',5,5'-tetramethoxymethyl-4,4'-dihydroxybiphenyl (for example, product name "TMOM-BP", made by Honshu Chemical Industry) and 1,1-bis[3,5-di(methoxymethyl)-4-hydroxyphenyl]-1-phenylethane, hexamethoxymethyl substituted triphenyl compound such as 4,4',4"-(ethylidene)trisphenol and other hexamethoxymethyl substituted compound (for example, product name "HMOM-TPHAP-GB", made by Honshu Chemical Industry), etc. may be mentioned.

As a melamine compound with an amino group substituted by two or more alkoxymethyl groups used as a compound containing two or more alkoxymethyl groups in its molecule, for example, N,N'-dimethoxymethyl melamine, N,N',N"-trimethoxymethyl melamine, N,N,N',N"-tetramethoxymethyl melamine, N,N,N',N',N"-pentamethoxymethyl melamine, N,N,N',N',N",N"-hexamethoxymethyl melamine (for example, "Nikalac MW-390LM" and "Nikalac MW-100LM", made by Sanwa Chemical), or polymers of the same etc. may be mentioned.

As a urea compound substituted by two or more alkoxymethyl groups used as a compound containing two or more alkoxymethyl groups in its molecule, "Nikalac MX270", made by Sanwa Chemical, "Nikalac MX280", made by Sanwa Chemical, "Nikalac MX290", made by Sanwa Chemical, etc. may be mentioned.

The compound containing two or more alkoxymethyl groups or methylol groups in its molecule can be used as single types alone or in combinations of two or more types.

Among these as well, from the viewpoint of the high reactivity, N,N,N',N',N",N"-hexamethoxymethyl melamine is preferable.

The molecular weight of the compound containing two or more alkoxymethyl groups in its molecule is not particularly limited, but is usually 50 to 100,000, preferably 80 to 10,000, more preferably 100 to 5,000. The compound containing two or more alkoxymethyl groups or methylol groups in its molecule can be used as single types alone or in combinations of two or more types.

The molecular weight of the cross-linking agent (C) is not particularly limited, but is usually 100 to 100,000, preferably 300 to 50,000, more preferably 500 to 10,000. The cross-linking agent (C) can be used as single types alone or in combinations of two or more types. Further, from the view point that it is possible to further improve the heat resistance of the obtained resin film, in the present invention, an epoxy group-containing cross-linking agent and alkoxymethyl group-containing cross-linking agent are preferably used in combination.

In the resin composition of the present invention, the content of the cross-linking agent (C) is preferably 5 to 80 parts by weight with respect to 100 parts by weight of the binder resin (A), more preferably 10 to 75 parts by weight, still more preferably 15 to 70 parts by weight. By making the content of the cross-linking agent (C) this range, it is possible to more suitably raise the heat resistance of the resin film obtained by the resin composition of the present invention. Note that when using two or more types of compounds as the cross-linking agent (C), the total content may be made the above range.

### (Photoacid Generator (D))

Further, the resin composition of the present invention may contain a photoacid generator (D) in addition to the binder resin (A), aromatic compound (B), and cross-linking agent (C). By including a photoacid generator (D), the photoacid generator (D) causes a chemical reaction if irradiated by radiation such as ultraviolet rays or electron beams, and it is possible to change the alkali solubility of the resin film formed by the resin composition and enable the resin film obtained by this to be patterned.

As the photoacid generator (D), for example, an acetophenone compound, triaryl sulfonium salt, an azide compound such as a quinone diazide compound, etc. may be mentioned, but preferably it is an azide compound, particularly preferably a quinone diazide compound.

As a quinone diazide compound, for example, an ester compound of a quinone diazide sulfonyl halide and a compound having a phenolic hydroxyl group may be used. As specific examples of a quinone diazide sulfonyl halide, 1,2-naphthoquinone diazide-5-sulfonyl chloride, 1,2-naphthoquinone diazide-4-sulfonyl chloride, 1,2-benzoquinone diazide-5-sulfonyl chloride, etc. may be mentioned. As typical examples of a compound having a phenolic hydroxy group, 1,1,3-tris(2,5-dimethyl-4-hydroxyphenyl)-3-phenylpropane, 4,4'-[1-[4-[1-[4-hydroxyphenyl]-1-methylethyl]phenyl]ethylidene]bisphenol, etc. may be mentioned. As a compound having a phenolic hydroxy group other than these, 2,3,4-trihydroxybenzophenone, 2,3,4,4'-tetrahydroxybenzophenone, 2-bis(4-hydroxyphenyl)propane, tris(4-hydroxyphenyl)methane, 1,1,1-tris(4-hydroxy-3-methylphenyl)ethane, 1,1,2,2-tetrakis(4-hydroxyphenyl)ethane, an oligomer of a novolac resin, an oligomer obtained by copolymerization of a compound having one or more phenolic hydroxy groups and dicyclopentadiene, etc. may be mentioned.

Further, as the photoacid generator (D), in addition to a quinone diazide compound, a known one such as an onium salt, halogenated organic compound, α,α'-bis(sulfonyl)diazomethane-based compound, α-carbonyl-α'-sulfonyl diazomethane-based compound, sulfone compound, organic acid ester compound, organic acid amide compound, and organic imide compound can be used.

These photoacid generators (D) can be used as single types alone or in combinations of two or more types.

In the resin composition of the present invention, the content of the photoacid generator (D) is preferably 5 to 100 parts by weight with respect to 100 parts by weight of the binder resin (A), more preferably 10 to 60 parts by weight, still more preferably 15 to 40 parts by weight. If the content of the photoacid generator (D) is in this range, when patterning the resin film comprised of the resin composition, the difference in solubility in the developing solution between the radiated parts and unradiated parts becomes greater, the radiation sensitivity also becomes higher, and patterning by development is easier, so this is preferable.

### (Other Compounding Agents)

Further, the resin composition of the present invention may further contain a solvent. The solvent is not particularly limited, but one known as a solvent of a resin composition, for example, acetone, methylethylketone, cyclopentanone, 2-hexanone, 3-hexanone, 2-heptanone, 3-heptanone, 4-heptanone, 2-octanone, 3-octanone, 4-octanone, or other straight chain ketones; n-propyl alcohol, isopropyl alcohol, n-butyl alcohol, cyclohexanol, or other alcohols; ethyleneglycol dimethyl ether, ethyleneglycol diethyl ether, dioxane, or other ethers; ethyleneglycol monomethyl ether, ethyleneglycol monoethyl ether, or other alcohol ethers; propyl formate, butyl formate, propyl acetate, butyl acetate, methyl propionate, ethyl propionate, methyl butyrate, ethyl butyrate, methyl lactate, ethyl lactate, or other esters; cellosolve acetate, methylcellosolve acetate, ethylcellosolve acetate, propylcellosolve acetate, butylcellosolve acetate, or other cellosolve esters; propyleneglycol, propyleneglycol monomethyl ether, propylene glycol monomethyl ether acetate, propylene glycol monoethyl ether acetate, propylene glycol monobutyl ether, or other propylene glycols; diethylene glycol monomethyl ether, diethylene glycol monoethyl ether, diethylene glycol dimethyl ether, diethylene glycol diethyl ether, diethylene glycol methylethyl ether, or other diethylene glycols; γ-butyrolactone, γ-valerolactone, γ-caprolactone, γ-caprylolactone, or other saturated γ-lactones; trichloroethylene or other halogenated hydrocarbons; toluene, xylene, or other aromatic hydrocarbons; dimethylacetoamide, dimethylformamide, N-methylacetoamide, or other polar solvents; etc. may be mentioned. These solvents may be used alone or as two types or more combined. The content of the solvent is preferably 10 to 10000 parts by weight with respect to 100 parts by weight of the binder resin (A), more preferably 50 to 5000 parts by weight, furthermore preferably 100 to 1000 parts by weight in range. Note that, when the resin composition is made to include a solvent, the solvent is normally removed after forming the resin film.

Further, the resin composition of the present invention may contain, if desired, in a range in which the effect of the present invention is not impaired, another compounding agent such as a compound having an acidic group or thermal latent acid group, a surfactant, sensitizer, photostabilizer, defoamer, pigment, dye, and filler. Among these, for example, for the compound having an acidic group or thermal latent acid group, ones described in Japanese Patent Publication No. 2014-29766A etc. may be used. Further, for the surfactant, sensitizer, and photostabilizer, ones described in Japanese Patent Publication No. 2011-75609A etc. may be used.

The method of preparation of the resin composition of the present invention is not particularly limited. It is sufficient to mix the ingredients forming the resin composition by a known method.

The method of mixing is not particularly limited, but mixing a solution or dispersion obtained by dissolving or dispersing the ingredients forming the resin composition in a solvent is preferable. Due to this, the resin composition is obtained in the form of a solution or dispersion.

The method of dissolving or dispersing the ingredients forming the resin composition may be an ordinary method. Specifically, this may be performed by stirring using a physical stirrer and magnetic stirrer, a high speed homogenizer, disperser, planetary stirrer, twin screw stirrer, ball mill, triple roll, etc. Further, it is possible to dissolve or disperse the components in a solvent, then, for example, filter the result using a filter with a pore size of 0.5 µm or so.

The solid concentration of the resin composition of the present invention is usually 1 to 70 wt%, preferably 5 to 60 wt%, more preferably 10 to 50 wt%. If the solid concentration is in this range, stability of dissolution, coatability, uniformity of thickness and flatness of the resin film which is formed, etc. are obtained in a high balance.

### (Electronic Device)

The electronic device of the present invention has a resin film comprised of the above-mentioned resin composition of the present invention.

The electronic device of the present invention is not particularly limited, but a resin film comprised of the resin composition of the present invention is excellent in heat resistance, waterproofness, thermal shock resistance, and solvent resistance, so the electronic device is preferably one produced by the wafer level package technology. In particular, a resin film comprised of the resin composition of the present invention is more preferably used for forming an interlayer insulating film for insulating between interconnects laid out in layers in an electronic device produced by the wafer level package technology.

In the electronic device of the present invention, the method of forming the resin film is not particularly limited. For example, a method such as the coating method or film lamination method may be used.

The coating method is, for example, the method of coating a resin composition, then drying by heating to remove the solvent. As the method of coating the resin composition, for example, various methods such as spray method, spin coat method, roll coat method, die coat method, doctor blade method, spin coat method, bar coat method, screen print method, and inkjet method can be employed. The heating and drying conditions differ according to the type and ratio of the ingredients, but are usually 30 to 150°C, preferably 60 to 120°C usually for 0.5 to 90 minutes, preferably 1 to 60 minutes, more preferably 1 to 30 minutes.

The film lamination method is a method comprising coating a resin composition on a resin film, metal film or other substrate for forming B-stage film, then heating and drying it to remove the solvent to obtain the B-stage film, then laminating this B-stage film. The heating and drying conditions may be suitably selected in accordance with the types and ratios of content of the ingredients, but the heating temperature is usually 30 to 150°C and the heating time is usually 0.5 to 90 minutes. The film lamination may be performed by using a press laminator, press, vacuum laminator, vacuum press, roll laminator, and other press bonding machines.

The thickness of the resin film is not particularly limited and may be suitably set in accordance with the application, but is preferably 0.1 to 100 µm, more preferably 0.5 to 50 µm, still more preferably 0.5 to 30 µm.

Further, the resin film which is formed by the above-mentioned coating method or film lamination method is cross-linked. This cross-linking may be performed by selecting a suitable method in accordance with the type of the cross-linking agent (C), but usually is performed by heating. The heating method, for example, may be one using a hot plate, oven, etc. The heating temperature is usually 150 to 250°C. The heating time is suitably selected in accordance with the area or thickness of the resin film, the equipment which is used, etc. For example, when using a hot plate, it is normally 5 to 60 minutes, while when using an oven, it is normally 30 to 300 minutes. The heating may be performed in accordance with need in an inert gas atmosphere. The inert gas may be one which does not contain oxygen and which does not oxidize a resin film. For example, nitrogen, argon, helium, neon, xenon, krypton, etc. may be mentioned. Among these as well, nitrogen and argon are preferable. In particular, nitrogen is preferable. In particular, inert gas with an oxygen content of 0.1 vol % or less, preferably 0.01 vol % or less, in particular nitrogen, is suitable. These inert gases may be respectively used alone or as two types or more combined.

Further, the resin film comprised of the resin composition can be patterned if necessary. As the method of patterning the resin film, for example, the method of including a photoacid generator (D) in the resin composition, forming a resin film before patterning, irradiating active radiation at the resin film before patterning to form latent patterns, then bringing the resin film which has the latent patterns into contact with the developing solution to bring out the patterns etc. may be mentioned. Alternatively, as the method of patterning, as a method other than a method using the photoacid generator (D), the method of using laser processing using a CO₂ laser or UV-YAG laser etc. or the method of forming a mask pattern on the resin film and then dry etching or further the inkjet method or other direct lithographic method etc. may be used.

The active radiation is not particularly limited so long as able to activate the photoacid generator (D) contained in the resin composition and change the alkali solubility of the resin composition containing the photoacid generator (D). Specifically, ultraviolet light, g-h-i-rays and other single wavelength ultraviolet light, KrF excimer laser light, ArF excimer laser light, and other light beams; electron beams and other particle beams; etc. may be used. As the method of selectively radiating active radiation in a pattern manner to form latent patterns, an ordinary method may be used. For example, the method of using a reduced projection exposure apparatus etc. to irradiate ultraviolet light, g-h-i-rays, KrF excimer laser light, ArF excimer laser light, and other light beams through a desired mask pattern or the method of using an electron beam or other particle beam for lithography etc. may be used. When using light beams as active radiation, single wavelength light or mixed wavelength light may be used. The irradiation conditions may be suitably selected in accordance with the active radiation used, but, for example, when using wavelength 200 to 450 nm light beams, the amount of irradiation is normally 10 to 1,000 mJ/cm², preferably 50 to 500 mJ/cm² in range and is determined in accordance with the irradiation time and illuminance. After irradiating the active radiation in this way, in accordance with need, the resin film is heat treated at 60 to 130°C or so in temperature for 1 to 2 minutes or so.

Next, the latent patterns which are formed in the resin film before patterning are developed to bring them out. As the developing solution, normally aqueous solutions of alkali compounds may be used. As alkali compounds, for example, alkali metal salts, amines, and ammonium salts may be used. The alkaline compounds may be inorganic compounds or organic compounds. As specific examples of these compounds, sodium hydroxide, potassium hydroxide, sodium carbonate, sodium silicate, sodium metasilicate, and other alkali metal salts; ammonia water; ethylamine, n-propylamine, and other primary amines; diethylamine, di-n-propylamine, and other secondary amines; triethylamine, methyldiethylamine, and other tertiary amines; tetramethylammonium hydroxide, tetraethylammonium hydroxide, tetrabutylammonium hydroxide, choline, and other quaternary ammonium salts; dimethylethanolamine, triethanolamine, and other alcohol amines; pyrrol, piperidine, 1,8-diazabicyclo[5.4.0]undec-7-ene, 1,5-diazabicyclo[4.3.0]non-5-ene, N-methylpyrrolidone, and other cyclic amines; etc. may be mentioned. These alkali compounds may be respectively used alone or as two types or more combined.

As the aqueous medium of the alkali aqueous solution, water; methanol, ethanol, and other water soluble organic solvents may be used. The alkali aqueous solution may have a surfactant etc. added in a suitable amount.

As the method for bringing the developing solution in contact with the resin film which has the latent patterns, for example, the puddle method, spray method, dipping method, and other methods may be used. The development conditions are suitably selected as normally 0 to 100°C, preferably 5 to 55°C, more preferably 10 to 30°C and normally 30 to 180 seconds.

The resin film formed with the targeted patterns in this way may, in accordance with need, be rinsed by a rinse solution to remove the developer residue. After the rinsing, the remaining rinse solution is removed by compressed air or compressed nitrogen.

Furthermore, in accordance with need, to deactivate the photoacid generator (D) contained in the resin composition, it is possible to irradiate the entire surface of the electronic device with activating radiation. The activating radiation can be irradiated utilizing the method illustrated for formation of the above latent patterns. The resin film may be heated at the same time as irradiation or after irradiation. As the heating method, for example, the method of heating the electronic device by a hot plate or in an oven may be mentioned. The temperature is usually 100 to 300°C, preferably 120 to 200°C in range.

In the present invention, the resin film may be cross-linked after patterning. The cross-linking can be performed by the above-mentioned method.

The resin composition of the present invention contains a binder resin (A), an aromatic compound (B) represented by the above general formula (1), and a cross-linking agent (C), so the resin film obtained by using such a resin composition of the present invention is excellent in heat resistance, waterproofness, thermal shock resistance, and solvent resistance. For this reason, such a resin film obtained using the resin composition of the present invention can be suitably used for electronic devices, in particular electronic devices produced by wafer level package technology.

### EXAMPLES

Below, examples and comparative examples will be given to explain the present invention more specifically. In the examples, "parts" are based on weight unless otherwise indicated.

Note that the definitions and methods of evaluation of the different characteristics are as follows:

### <Heat Resistance>

A resin composition was spin coated on a silicon wafer formed with a thin film of aluminum of a thickness of 100 nm using a sputtering apparatus, then was heated using a hot plate at 120°C for 2 minutes. Next, the composition was cured in a nitrogen atmosphere at 200°C for 60 minutes to form a resin film of a thickness of 10 µm and thereby obtain a laminate. The obtained laminate was cut into a predetermined size, then the aluminum film was made to dissolve in a 0.1 mol/L hydrochloric acid aqueous solution and the remaining film was peeled off. The peeled off film was dried to obtain the resin film. Further, the obtained resin film was measured for glass transition temperature (°C) of the resin film using a viscoelasticity spectrometer (SII Nanotechnology, DMS6100 standard model) and was evaluated for heat resistance by the following criteria. The higher the glass transition temperature, the better the heat resistance can be judged to be.
A: Glass transition temperature of 160°C or more
B: Glass transition temperature of 150°C to less than 160°C
C: Glass transition temperature of less than 150°C

### <Waterproofness>

A resin composition was spin coated on a silicon wafer formed with a film of copper of a thickness of 100 nm on a film of titanium of a thickness of 50 nm using a sputtering apparatus, then was heated using a hot plate at 120°C for 2 minutes. Next, the composition was cured in a nitrogen atmosphere at 200°C for 60 minutes to form a resin film of a thickness of 10 µm and thereby obtain a laminate. The obtained laminate was placed in a high temperature, high humidity tank of a temperature of 130°C and a humidity of 85RH% for 200 hours, then the laminate was taken out and the resin film forming the laminate was subjected to a cross cut test. Specifically, first, a cutter knife was used to cut the resin film forming the laminate into a grid of 10×10=100 squares of 1 mm x 1 mm size. Further, cellophane tape was strongly pressed against the grid parts then the cellophane tape was stripped off all at once from the end by an angle of 45°. The remaining ratio of resin film (ratio of resin film remaining on silicon wafer formed with a film of copper to a thickness of 100 nm on a titanium film of 50 nm thickness using a sputtering apparatus) was found. The following criteria were used to evaluate the waterproofness (the adhesion after high temperature, high humidity test).
A: Remaining ratio of resin film of 90% or more
B: Remaining ratio of resin film of 80% to less than 90%
C: Remaining ratio of resin film of less than 80%

### <Thermal Shock Resistance>

A resin composition was spin coated on the substrate for evaluation of thermal shock having patterns of copper interconnects on a silicon wafer, then was heated in a nitrogen atmosphere at 120°C for 2 minutes, then was cured at 200°C for 60 minutes to form a resin film of a thickness of 10 µm and thereby obtain a sample for evaluation. Further, the obtained sample for evaluation was tested for thermal shock using a thermal shock tester (made by Tabai Espec) in cycles of -55°C/30 minutes and 150°C/30 minutes. The number of cycles until cracks formed in the resin film was confirmed. The following criteria were used to evaluate the thermal shock resistance.
A: No cracks formed even after elapse of 1000 cycles
C: Cracks formed before reaching 1000 cycles

### <Solvent Resistance>

A resin composition was spin coated on a silicon wafer, then was heated using a hot plate at 120°C for 2 minutes, then was cured in a nitrogen atmosphere at 200°C for 60 minutes to form a resin film of a thickness of 10 µm and thereby obtain a laminate. Further, the obtained laminate was immersed in N-methyl-2-pyrrolidone at room temperature for 10 minutes, then the immersed resin film was measured for change in thickness and checked for the presence of any cracks. The following criteria were used to evaluate the solvent resistance.
A: Amount of change of thickness of resin film of less than 1% and no cracks formed in resin film
B: Amount of change of thickness of resin film 1% or more and no cracks formed in resin film
C: Cracks formed in resin film

### <<Synthesis Example 1>>

### <Preparation of Cyclic Olefin Polymer (A-1)>

100 parts of a monomer mixture comprised of 40 mol% of N-phenyl-bicyclo[2.2.1]hept-5-ene-2,3-dicarboxyimide (NBPI) and 60 mol% of 4-hydroxycarbonyltetracyclo[6.2.1.1^{3,6}.0^{2,7}]dodec-9-ene (TCDC), 2.0 parts of 1,5-hexadiene, 0.02 part of (1,3-dimesityl imidazolin-2-ylidene)(tricyclohexyl phosphine)benzylidene ruthenium dichloride (synthesized by method described in Org. Lett., vol. 1, p. 953, 1999), and 200 parts of diethylene glycol ethyl methyl ether were charged into a glass pressure resistant reactor inside of which the atmosphere was substituted with nitrogen. These were stirred while causing them to react at 80°C for 4 hours to obtain a polymerization reaction solution.

Further, the obtained polymerization reaction solution was placed into an autoclave and stirred at 150°C and a hydrogen pressure of 4 MPa for 5 hours to cause a hydrogenation reaction and obtain a polymer solution containing a cyclic olefin polymer (A-1). The polymerization conversion rate of the obtained cyclic olefin polymer (A-1) was 99.7%, the weight average molecular weight converted to polystyrene was 7,150, the number average molecular weight was 4,690, the molecular weight distribution was 1.52, and the hydrogenation rate was 99.7%. Further, the solid concentration of the obtained polymer solution of the cyclic olefin polymer (A-1) was 34.4 wt%.

### <<Example 1>>

291 parts of a binder resin (A) comprised of a polymer solution of the cyclic olefin polymer (A-1) obtained in Synthesis Example 1 (100 parts as cyclic olefin polymer (A-1)), 5 parts of an aromatic compound (B) comprised of 4-methyl catechol (compound of the above general formula (2) in which R¹=OH, R²=OH, R³=H, R⁴=CH₃, R⁶=H, and R⁷=H), 30 parts of a cross-linking agent (C) comprised of epoxylated butanetetracarboxylic acid tetrakis(3-cyclohexenylmethyl)-modified ε-caprolactone (product name "Epolide GT401", made by Daicel Chemical Industries, aliphatic cyclic tetrafunctional epoxy resin), 10 parts of a cross-linking agent (C) comprised of N,N,N',N',N",N"-hexamethoxymethyl melamine (product name "Nikalac MW-100LM", made by Sanwa Chemical), 3 parts of a silane coupling agent comprised of γ-glycidoxypropyltrimethoxysilane (product name "Z6040", made by Toray-Dow Corning), and 160 parts of a solvent comprised of diethyleneglycol ethylmethyl ether were mixed and made to dissolve, then were filtered by a pore size 0.45 µm polytetrafluoroethylene filter to prepare a resin composition.

Further, the obtained resin composition was used to measure and evaluate the heat resistance, waterproofness, thermal shock resistance, and solvent resistance. The results are shown in Table 1.

### <<Examples 2 to 4>>

Except for using the compounds shown in Table 1 in the amounts shown in Table 1, the same procedures were followed as in Example 1 to prepare resin compositions and the same procedures were followed to evaluate them. The results are shown in Table 1.

### <<Comparative Examples 1 to 3>>

Except for using the compounds shown in Table 1 in the amounts shown in Table 1, the same procedures were followed as in Example 1 to prepare resin compositions and the same procedures were followed to evaluate them. The results are shown in Table 1.

### Table 1

**Table 1**

| | | | Examples | | | | Comparative Examples | | |
|---|---|---|---|---|---|---|---|---|---|
| | | | 1 | 2 | 3 | 4 | 1 | 2 | 3 |
| Binder resin (A) | Cyclic olefin polymer(A-1) | (parts) | 100 | 100 | | | 100 | | 100 |
| | Acrylic polymer (Maruka Linker CMM) | (parts) | | | 100 | 100 | | 100 | |
| Aromatic compound (B) | 4-methyl catechol | (parts) | 5 | | | | | | |
| | 1,2,3-trihydroxybenzene | (parts) | | 5 | | 5 | | | |
| | Phloroglucinol | (parts) | | | 5 | | | | |
| Aromatic compound other than aromatic compound (B) | 2,5-dimethyl phenol | (parts) | | | | | 5 | | |
| | Phenol novolac resin (PAPS-PN2) | (parts) | | | | | | | 5 |
| Cross-linking agent © | Epolide GT401 | (parts) | 30 | 30 | 30 | 30 | 40 | 30 | 30 |
| | Celloxide 2081 | (parts) | | | | 10 | 20 | 10 | |
| | EXA-4816 | (parts) | | 20 | 20 | | | | |
| | Nikalac MW100LM | (parts) | 10 | | | | | 10 | |
| | HMOM-TPHAP-GB | (parts) | | | | 7 | | | 7 |
| Photoacid generator (D) | TS200 | (parts) | | 25 | | 30 | | | |
| Silane coupling agent | Z6040 | (parts) | 3 | | 3 | | 3 | | |
| | Z6883 | (parts) | | 3 | | 3 | | 3 | 3 |
| Results of evaluation | Heat resistance | | A | A | B | A | B | B | A |
| | Waterproofness | | A | A | B | B | A | C | B |
| | Thermal shock resistance | | A | A | A | A | A | A | C |
| | Solvent resistance | | A | A | A | A | C | B | A |

Note that in Table 1, the compounds shown are as follows:
Binder resin (A) "Cyclic olefin polymer (A-1)": cyclic olefin polymer (A-1) obtained in Synthesis Example 1
Binder resin (A) "Acrylic polymer (Maruka Linker CMM)": acrylic polymer (product name "Maruka Linker CMM", made by Maruzen Petrochemical, copolymer of p-hydroxystyrene and methyl methacrylate)
Aromatic compound (B) "4-methyl catechol": 4-methyl catechol (compound of above general formula (2) in which R¹=OH, R²=OH, R³=H, R⁴=CH₃, R⁶=H, and R⁷=H)
Aromatic compound (B) "1,2,3-trihydroxybenzene": 1,2,3-trihydroxybenzene (compound of above general formula (2) in which R¹=OH, R²=OH, R³=OH, R⁴=H, R⁶=H, and R⁷=H)
Aromatic compound (B) "Phloroglucinol": Phloroglucinol (compound of above general formula (2) in which R¹=OH, R²=H, R³=OH, R⁴=H, R⁶=OH, and R⁷=H)
Aromatic compound other than aromatic compound (B) "2,5-dimethyl phenol": 2,5-dimethyl phenol (compound of above general formula (2) in which R¹=OH, R²=CH₃, R³=H, R⁴=H, R⁶=CH₃, and R⁷=H)
Aromatic compound other than aromatic compound (B) "Phenol novolac resin (PAPS-PN2)": phenol novolac resin (product name "PAPS-PN2", made by Asahi Yukizai, medium molecular weight type)
Cross-linking agent (C) "Epolide GT401": epoxylated butanetetracarboxylic acid tetrakis(3-cyclohexenylmethyl)-modified ε-caprolactone (product name "Epolide GT401", made by Daicel Chemical Industries, aliphatic cyclic tetrafunctional epoxy resin)
Cross-linking agent (C) "Celloxide 2081": ε-caprolactone-modified 3',4'-epoxycyclohexylmethyl-3,4-epoxycyclohexane carboxylate (product name "Celloxide 2081", made by Daicel Chemical Industries)
Cross-linking agent (C) "EXA-4816": long chain bisphenol A type epoxy resin (product name "EXA-4816", made by DIC)
Cross-linking agent (C) "Nikalac MW100LM": N,N,N',N',N",N"-hexamethoxymethyl melamine (product name "Nikalac MW-100LM", made by Sanwa Chemical)
Cross-linking agent (C) "HMOM-TPHAP-GB": 4,4',4"-(ethylidene)trisphenol or other hexamethoxymethyl substituted compound (product name "HMOM-TPHAP-GB", made by Honshu Chemical Industry)
Photoacid generator "TS200": condensate of 4,4'-[1-[4-[1-[4-hydroxyphenyl]-1-methylethyl]phenyl]ethylidene]bisphenol (1 mole) and 1,2-naphthoquinone diazide-5-sulfonyl chloride (2.0 moles) (product name "TS200", made by Toyogosei)
Silane coupling agent "Z6040": γ-glycidoxypropyl trimethoxysilane (product name "Z6040", made by Toray-Dow Corning)
Silane coupling agent "Z6883": 3-phenylaminopropyl trimethoxysilane (product name "Z6883", made by Toray-Dow Corning)

As shown in Table 1, resin films obtained using a resin composition containing a binder resin (A), an aromatic compound (B) represented by the above general formula (1), and a cross-linking agent (C) were excellent in each of heat resistance, waterproofness, thermal shock resistance, and solvent resistance (Examples 1 to 4).

On the other hand, when using 2,5-dimethyl phenol having only one hydroxyl group instead of the aromatic compound (B) represented by the above general formula (1), the obtained resin film was insufficiently cross-linked and inferior in solvent resistance (Comparative Example 1).

Further, when the aromatic compound (B) represented by the above general formula (1) was not mixed in, the obtained resin film was inferior in waterproofness (Comparative Example 2).

Furthermore, when a phenol novolac resin was used instead of the aromatic compound (B) represented by the above general formula (1), the obtained resin film was inferior in thermal shock resistance (Comparative Example 3).

## Claims

1. A resin composition comprising a binder resin (A), an aromatic compound (B) represented by the following general formula (1), and a cross-linking agent (C): 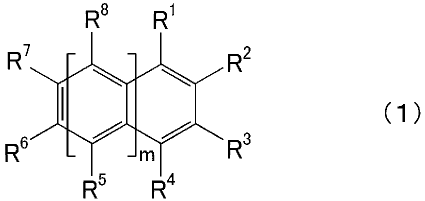 where in the general formula (1), each of R¹ to R⁸ respectively independently is hydrogen atom, hydroxyl group, carboxyl group, substituted or unsubstituted aliphatic hydrocarbon group having 1 to 12 carbon atoms, or substituted or unsubstituted aromatic hydrocarbon group having 6 to 12 carbon atoms, "m" is an integer of 0 to 2, when "m" is 0, at least two of R¹ to R⁴, R⁶, and R⁷ are hydroxyl group, when "m" is 1 or 2, at least two of R¹ to R⁸ are hydroxyl group, and, when "m" is 2 or more, regardless of the structure represented by general formula (1), three or more benzene rings present may be joined with each other at any positions.

2. The resin composition according to claim 1, further comprising a photoacid generator (D).

3. The resin composition according to claim 2, wherein the photoacid generator (D) is a quinone diazide compound.

4. The resin composition according to any one of claims 1 to 3, wherein the binder resin (A) is a cyclic olefin polymer having a protic polar group.

5. The resin composition according to any one of claims 1 to 4, wherein the aromatic compound (B) is a compound represented by the following general formula (2): 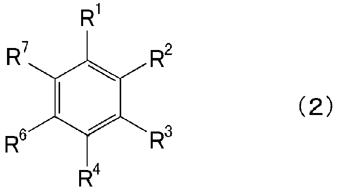 where in the general formula (2), R¹ to R⁴, R⁶, and R⁷ are the same as in the general formula (1) and at least two of R¹ to R⁴, R⁶, and R⁷ are hydroxyl group.

6. The resin composition according to claim 5, wherein the aromatic compound (B) is
a compound represented by the general formula (2) in which two of R¹ to R⁴, R⁶, and R⁷ are hydroxyl group, one of R¹ to R⁴, R⁶, and R⁷ is an aliphatic hydrocarbon group having 1 to 12 carbon atoms, and the remainder are hydrogen atom, or
a compound represented by the general formula (2) in which three of R¹ to R⁴, R⁶, and R⁷ are hydroxyl group and the remainder are hydrogen atom.

7. The resin composition according to any one of claims 1 to 6, wherein a content of the aromatic compound (B) is 0.01 to 30 parts by weight with respect to 100 parts by weight of the binder resin (A).

8. The resin composition according to any one of claims 1 to 7, wherein the cross-linking agent (C) is an epoxy group-containing cross-linking agent.

9. An electronic device having a resin film comprised of a resin composition according to any one of claims 1 to 8.
